# EUROPEAN PATENT APPLICATION

(11) **EP 1 471 526 A2**
(43) Date of publication of application: **27.10.2004**
(21) Application number: 04017916.0
(22) Date of filing: 05.02.2002
(51) Int. Cl.: G11B 20/12

(54) **Method for recording main data on an optical information recording medium**

(30) Priority: 20.04.2001 KR 2001021521
(62) Divisional of application: 02250753.7
(71) Applicant: Samsung Electronics Co., Ltd., Suwon-si, Gyeonggi-do (KR)
(72) Inventor: Hwang, Sung-hee, Gangnam-gu Seoul (KR); Lee, Yoon-woo, Paldal-gu Suwon-gi Gyeonggi-do (KR); Han, Sung-hyu, Youngdeungpo-gu Seoul (KR); Ryu, Sang-hyun, Suwon-si Gyeonggi-do (KR)
(74) Representative: Kohler, Janet Wendy

(57) **Abstract**

A method for recording main data on an optical information recording medium is provided. The method comprises error correction code (ECC) encoding main data to generate a plurality of ECC blocks, each ECC block comprising a plurality of sectors having corresponding identifiers, and extracting and arranging the identifiers from ones of the ECC blocks to generate a recording block such that adjacent identifiers are of different ECC blocks. As a result, the data recording method used by the apparatus has a higher error correction rate.

## Description

The present invention relates to error correction, and, more particularly, to a method for recording data on an optical information recording medium which is capable of recording high density data.

Digital broadcasting will soon be commonly used in many countries of the world. However, current digital versatile discs (DVDs) have a capacity of 4.7-10 gigabytes, and thus a two-hour movie (about 25 gigabytes) which is received via digital broadcasting cannot be recorded in a disc. As a result, a high density recording medium for recording a digital broadcast having the size of a movie is required.

A method for reducing the size of a laser beam used in recording/reading data is a representative example of a method for increasing recording density. The smaller the radius of the laser beam the more densely an information track in which data are recorded can be formed, thereby increasing recording density. However, if only the radius of the laser beam is decreased, the quantity of light used in recording/reading data is also reduced, and the effect caused by damage or dust occurring on the surface of the disc is relatively increased. That is, an error generation rate in recording/reading data is increased.

US 6539512B1 shows an interleaving method for a high density recording medium and an interleaving circuit therefore. In this circuit, an intrablock interleaver interleaves received data having a predetermined error correction code within an error correction block to output intrablock-interleaved data. An interblock interleaver interleaves the intrablock-interleaved data between the error correction blocks in units of a predetermined number of the error correction blocks to output interblock-interleaved data. This document forms the precharacterising portion of the claims appended hereto.

It is an aim of the present invention to provide an optical information recording medium, a data recording apparatus, and a data recording method used by the apparatus, which have higher error correction rates in recording/reading data.

It is a second aim of the present invention to provide an optical information recording medium, a data recording apparatus, and a data recording method used by the apparatus which are capable of searching main data at a high speed and have lower error rates.

It is a third aim of the present invention to provide an optical information recording medium, a data recording apparatus, and a data recording method used by the apparatus, which are compatible with the format of a conventional digital versatile disc (DVD) and have higher error correction rates.

According to one aspect of the present invention there is provided a method for recording main data on an optical information recording medium. The method includes the steps of (a) error correction code (ECC)-encoding main data to generate a plurality of ECC blocks, and (b) sequentially extracting identifiers included in a plurality of sectors which comprise the generated plurality of ECC blocks so that the ECC blocks are equally selected and sequentially arranging the identifiers at a predetermined interval to generate a recording block.

The method may further comprise the steps of: (c) modulating the generated recording block; and (d) recording the modulated recording block.

The step (b) may include the steps of (b1) sequentially extracting the identifiers so that the ECC blocks are equally selected and arranging the extracted identifiers in the recording block at a predetermined interval, and (b2) interleaving ECC-encoded main data included in the sectors corresponding to the arranged identifiers.

The step (b2) of interleaving may be performed in units of one or more rows or in units of at least part of the sectors.

According to another aspect of the present invention there is provided a method for recording main data on an optical information recording medium. The method includes the steps of (a) error correction code (ECC)-encoding main data to generate first and second ECC blocks, (b) arranging an identifier included in the first sector of the first ECC block as a first identifier, arranging an identifier included in the first sector of the second ECC block as a second identifier, arranging an identifier included in the second sector of the first ECC block as a third identifier, arranging an identifier included in the second sector of the second ECC block as a fourth identifier, and arranging identifiers included in the remaining sectors of the first and second ECC blocks with the same algorithm, and (c) interleaving ECC-encoded main data included in the first sectors of the first and second ECC blocks to sequentially correspond to the first arranged identifier and the second arranged identifier, interleaving ECC-encoded main data included in the second sectors of the first and second ECC blocks to correspond to the third and fourth identifiers, and interleaving ECC-encoded main data included in the remaining sectors of the first and second ECC blocks with the same algorithm to generate a recording block.

The method may further comprise the steps of: (d) modulating the generated recording block; and (e) recording the modulated recording block.

The identifiers may be alternately and equally extracted and arranged at predetermined intervals in the step (b). The step (c) of interleaving may be performed in units of one or more rows or in units of at least part of the sectors.

For a better understanding of the invention, and to show how embodiments of the same may be carried into effect, reference will now be made, by way of example, to the accompanying diagrammatic drawings in which:
Figures 1A and 1B are block diagrams of a data recording apparatus according a preferred embodiment of the present invention;
Figures 2A and 2B illustrate the format of error correction code (ECC) blocks for interleaving according to the preferred embodiment of the present invention;
Figure 3 illustrates the format of a block generated by in-block interleaving of Figure 2A according to the preferred embodiment of the present invention;
Figure 4 illustrates the format of ECC blocks A and B for interleaving according to the present invention;
Figure 5 illustrates the format of a recording block according to the present invention;
Figure 6 is an example of the recording block generated by between-block interleaving of Figure 5 according to the present invention;
Figure 7 illustrates the largest error of a recording block according to the present invention that can be corrected by error correction according to the present invention;
Figure 8 illustrates the recording block in which the largest error occurs, rearranged on the basis of the ECC blocks A and B of Figure 7;
Figures 9A and 9B are block diagrams of a data reproducing apparatus according to the present invention; Figure 10 is a schematic flow chart illustrating a data recording method according to the present invention; and
Figure 11 is a flow chart illustrating a data recording method according to the preferred embodiment of the present invention.

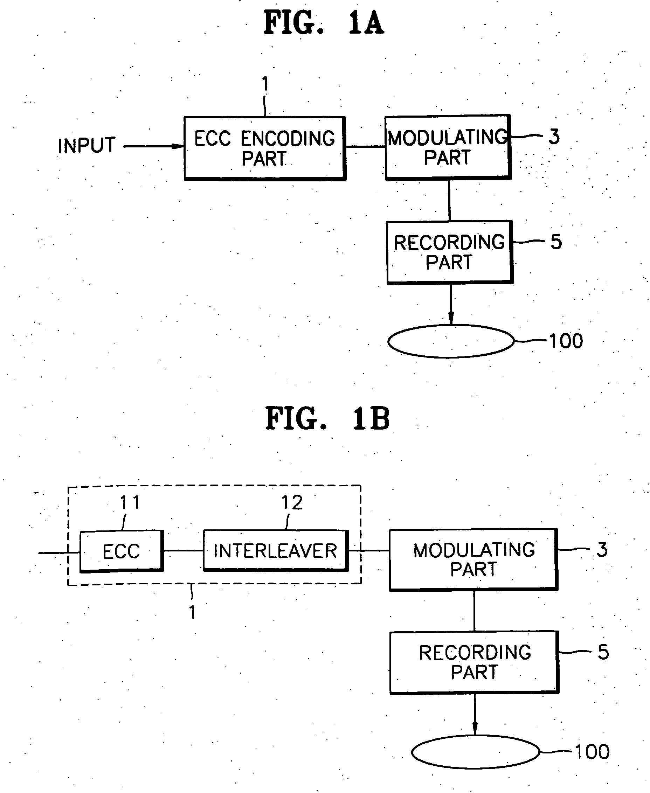

Figures 1A and 1B are block diagrams of a data recording apparatus according a preferred embodiment of the present invention. Referring to Figures 1A and 1B, the data recording apparatus includes an error correction code (ECC) encoding part 1, a modulating part 3, and a recording part 5. The ECC encoding part 1 includes an ECC encoder 11 and an interleaver 12. The ECC encoder 11 encodes main data with an error-correction-code (ECC). The interleaver 12 interleaves the ECC-encoded main data according to the present invention and generates a recording block. Interleaving is done to increase error correction efficiency and is a method for physically distributedly recording contiguous main data in ECC blocks on an optical disc. Burst error can be very effectively corrected by interleaving. A more specific interleaving method will be described later.

The modulating part 3 modulates the recording block generated by the ECC encoding part 1 according to a predetermined modulating method. The modulating method used in this embodiment is eight to fourteen modulation plus (EFM+), that is, a method for modulating each byte of the recording block data into a 16 bit code word. The recording part 5 records the modulated recording block on an optical disc 100. When recording the modulated recording block on the optical disc 100, a channel bit pulse stream which a modulated bit stream is converted into by non return to zero inversion (NRZI) coding according to the embodiment, is recorded. Here, various converting methods for recording the channel bit pulse stream can be used.

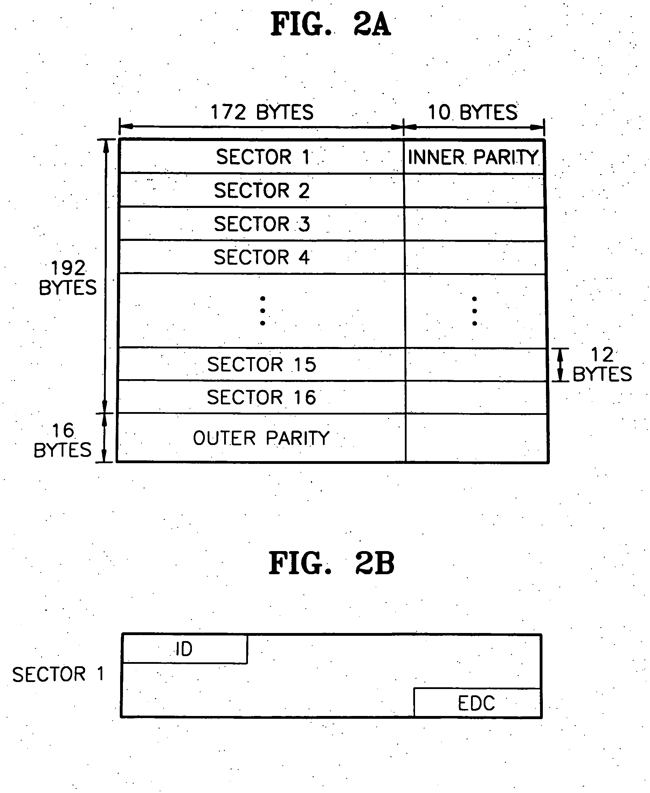

Figures 2A and 2B illustrate the format of error correction code (ECC) blocks for interleaving according to the preferred embodiment of the present invention. Referring to Figure 2A, the ECC blocks consist of 182 bytes of data in a row direction, and 208 bytes of data in a column direction. 172 byes of main data and 10 bytes of an inner parity of a row-code word are arranged in a row direction, and 16 sectors and 16 bytes of an outer parity are arranged in a column direction. 12 bytes of one sector is arranged in a column direction. The row-code words can be obtained by Reed-Solomon Product coding. That is, each row is a RS(182, 172, 11) code, and each column is a RS(208, 192, 17) code. Here, 182 and 208 are the total size of the code words, 172 and 192 are the size of the main data, and 11 and 17 are the number of parity bytes plus one byte. Since Reed-Solomon Product coding is good at correcting multi-errors and is used in digital versatile discs (DVD), in this embodiment, Reed-Solomon Product coding is selected for compatibility with DVDs. However, the coding method used can be changed when needed. Similarly, the size of the ECC blocks and the number of bytes allocated to the parity can be changed.

Referring to Figure 2B, 12 bytes of an identifier ID and 4 bytes of a parity for error detection and correction (EDC) are included in each sector. The address of the main data included in the corresponding sector is recorded in the identifier ID. Thus, the main data can be searched by the identifier ID.

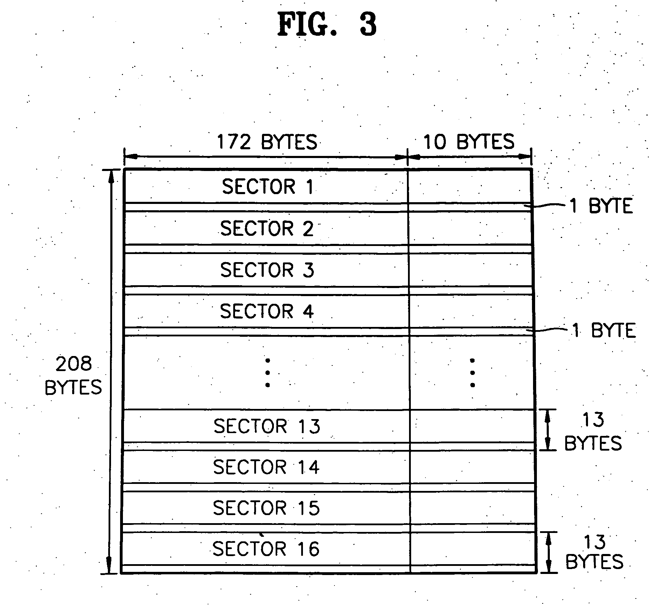

Figure 3 illustrates the format of a block generated by in-block interleaving of Figure 2A according to the preferred embodiment of the present invention. Referring to Figure 3, the ECC blocks are interleaved in the block according to the preferred embodiment of the present invention. In other words, 16 bytes of an outer parity is included at the end of each sector in units of one row in the same way as row-interleaving defined in a DVD format. As a result, many unbalances (caused by the difference of an outer parity block) occurring when the ECC blocks are recorded by the above method can be removed.

Interleaving in the block, i.e. "in-block interleaving" used in this embodiment is performed in consideration of interchangeability with a DVD and uniformity of data included in the ECC blocks, but may be not used as occasion demands.

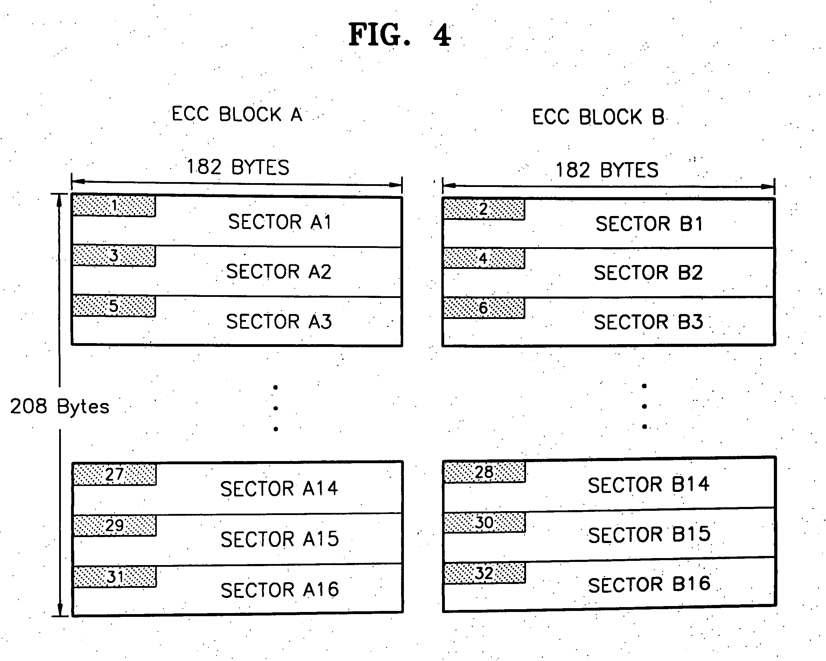

Figure 4 illustrates the format of ECC blocks A and B for interleaving according to the present invention. Referring to Figure 4, as described in Figures 2 and 3, the ECC block A consists of sector A1, ..., sector A16, and the ECC block B consists of sector B1, .., sector B16. An identifier ID is included in each sector. Also, main data corresponding to the arranged identifier ID are arranged in each sector. In other words, the order of arrangement of the identifier ID is the same as the order of arrangement of the sector of the main data.

Assuming that the ECC blocks A and B are interleaved in the blocks, i.e. "between blocks interleaved" to generate one recording block, the order of arrangement of the identifier ID in the recording block is shown in Figure 4. In other words, the identifiers of the sectors included in the ECC blocks A and B are alternately and equally extracted and arrange so that the corresponding ECC blocks are alternately selected.
(1) Identifier of A1 ⇒ (2) Identifier of B1 ⇒ (3) Identifier of A2 ⇒ (4) Identifier of B2 ⇒ (5) Identifier of A3 ⇒ (6) Identifier of B3 ⇒, .., ⇒ (31) Identifier of A16 ⇒ (32) Identifier of B16

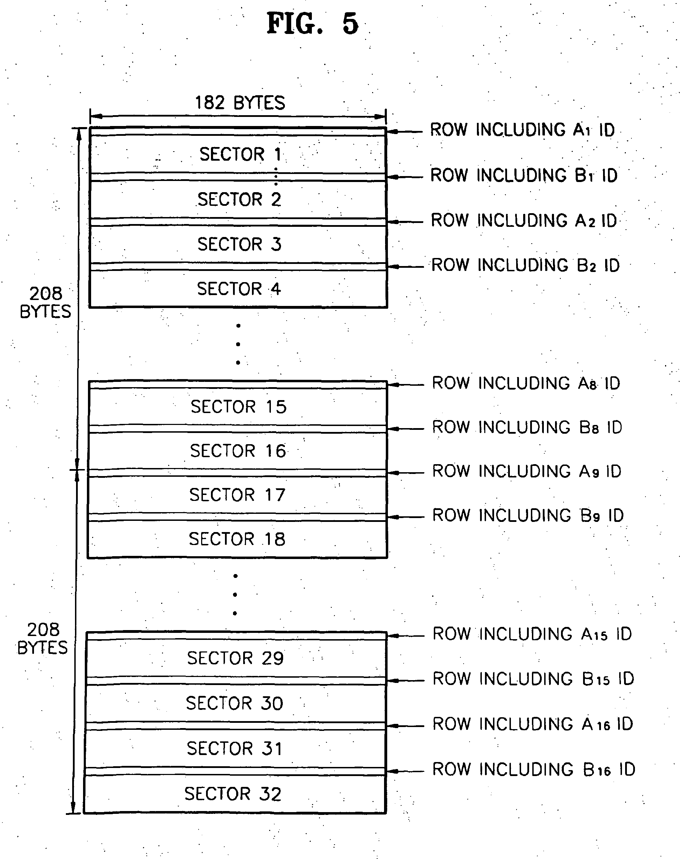

Figure 5 illustrates the format of a recording block according to the present invention. Referring to Figure 5, the recording block is obtained by interleaving in the block with the ECC blocks A and B of Figure 4. The recording block has a size of 208 x 2 bytes in a column direction and a size of 182 bytes in a row direction. New 32 sectors, which are generated by interleaving the 16 sectors (A1, .., A16) included in the ECC block A of Figure 4 and the 16 sectors (B1, .., B16) included in the ECC block B of Figure 4, are arranged in the recording block. In particular, a row-code word, in which the identifier ID of each sector is included, is in the first row of each sector. That is, the identifiers in the recording block are arranged in the order in which the identifiers of the sectors included in the ECC blocks A and B are alternately and equally extracted and arranged, as described with reference to Figure 4.

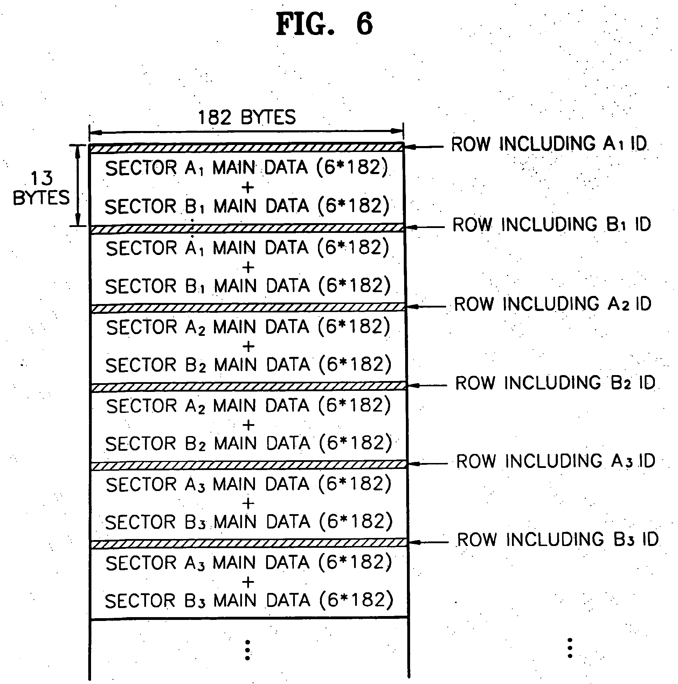

Figure 6 is an example of the recording block generated by interleaving of Figure 5 according to the present invention. Referring to Figure 6, a row-code word including an identifier ID, row-code words (ECC-encoded main data) included in the top half of the first sector A1 of the ECC block A, and row-code words (ECC-encoded main data) included in the top half of the first sector B1 of the ECC block B are interleaved in a first sector of the recording block. There are many interleaving methods. More specifically, the ECC-encoded main data can be interleaved in units of one or more rows, or in units of at least of part of the sectors.

Similarly, a row-code word including an identifier ID, row-code words (ECC-encoded main data) included in the bottom half of the first sector Al of the ECC block A, and row-code words (ECC-encoded main data) included in the bottom half of the first sector B1 of the ECC block B are interleaved in a second sector of the recording block. The subsequent sectors are constituted by the same method.

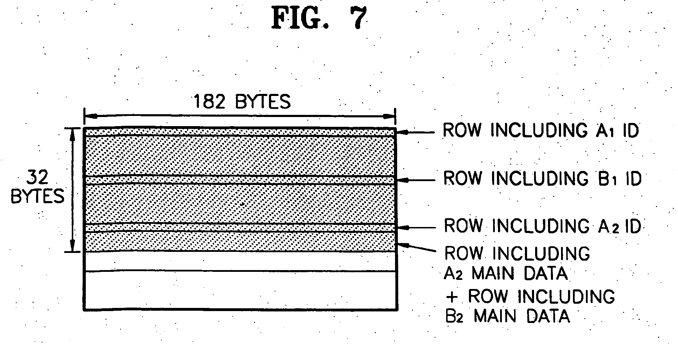

Figure 7 illustrates the largest error that can be corrected by error correction according to the present invention. Since each of the ECC blocks A and B can correct an error of each 16 bytes in a column direction, as shown in Figure 7, the largest error-generated range in which error correction is possible is a case where errors occur in 1 row including the identifier ID of a sector A1, 6 rows of the sector A1, 6 rows of a sector B1, 1 row including the identifier ID of the sector B1, the remaining 6 rows of the sector A1, the remaining 6 rows of the sector B1, 1 row including the identifier ID of a sector A2, 2 rows of the sector A2, and 3 rows of a sector B2. That is, for the ECC block A, errors occur in 1 + 6 + 6 + 1 + 2 = 16 rows, and for the ECC block B, errors occur in 6 + 1 + 6 + 3 = 16 rows. Thus, the sum of the rows in which errors occur is 32 rows. The size of data becomes 32 x 182 bytes.

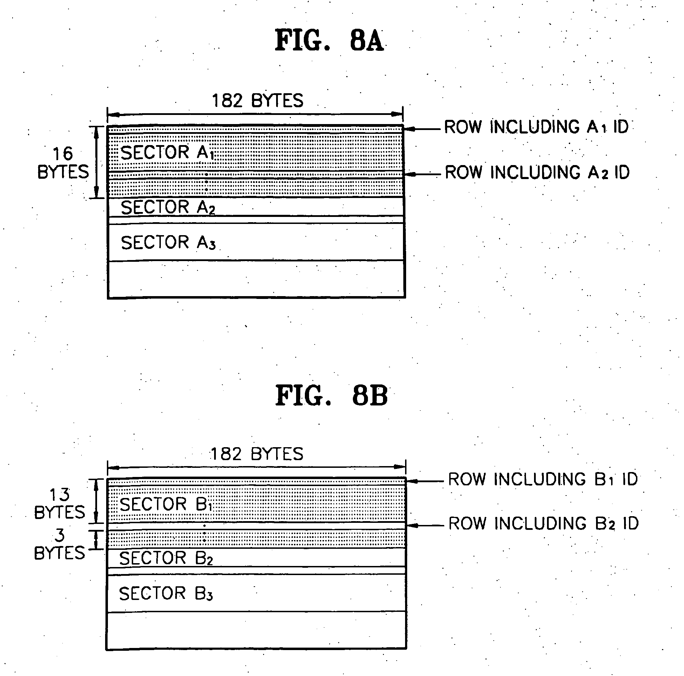

Figure 8 illustrates the recording block in which the largest error occurs, rearranged on the basis of the ECC blocks A and B of Figure 7. Figure 8A is a schematic view of the ECC block A which is generated by de-interleaving the recording block in which the largest error occurs, and Figure 8B is a schematic view of the ECC block B which is generated by de-interleaving the recording block in which the largest error occurs. The error occurring in the ECC block A is 16 bytes in total, and the error occurring in the ECC block B is also 16 bytes in total. That is, since each of the ECC blocks A and B can correct an error of each 16 bytes in a column direction, each error can be corrected.

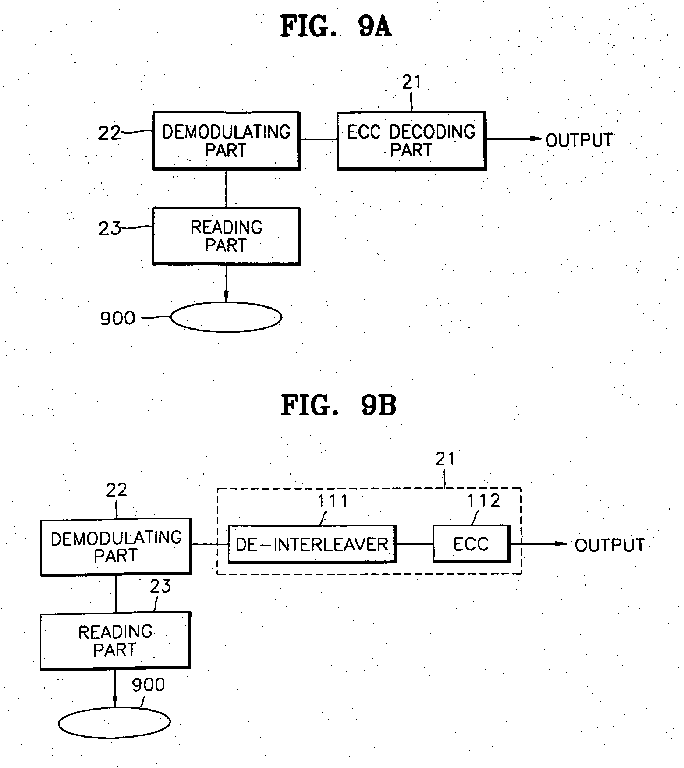

Figures 9A and 9B are block diagrams of a data reproducing apparatus according to the present invention. Referring to Figure 9A, the data reproducing apparatus includes a reading part 23, a demodulating part 22, and an ECC decoding part 21. The reading part 23 reads data from an optical disc 900 on which data are recorded according to the present invention. The demodulating part 22 demodulates the read data. The demodulating method used depends on the modulating method.

The ECC decoding part 21 ECC-decodes the demodulated data, that is, a recording block. More specifically, referring to Figure 9B, the ECC decoding part 21 includes a de-interleaver 111 and an ECC decoder 112. The de-interleaver 111 de-interleaves the recording block in the order reverse to the interleaver 12 of Figure 1B to generate a plurality of error correction code (ECC) blocks. The ECC decoder 112 decodes the demodulated data into main data with an ECC, which are used in the generated ECC block, and outputs the main data.

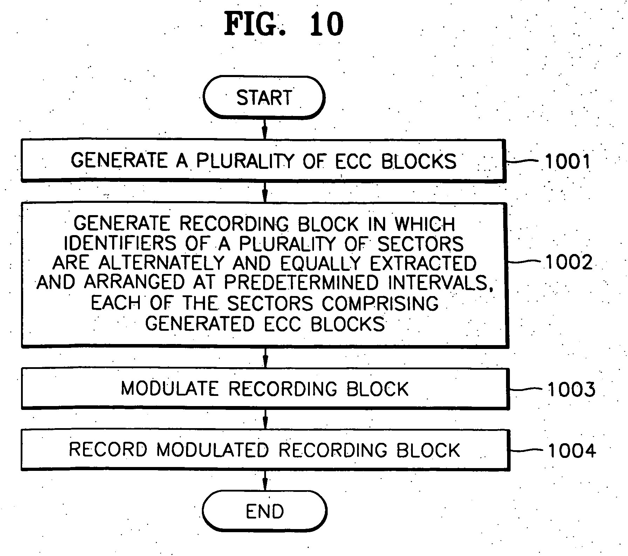

Figure 10 is a schematic flow chart illustrating a data recording method according to the present invention. Referring to Figure 10, in step 1001, an ECC encoder 11 ECC-encodes main data to generate a plurality of ECC blocks.

In step 1002, an interleaver 12 generates a recording block in which identifiers of a plurality of sectors are alternately and equally extracted and arranged at predetermined intervals, each of the sectors comprising generated ECC blocks. More specifically, identifiers in an ECC block and identifiers in the remaining ECC blocks are alternately and equally extracted and arranged at predetermined intervals in the recording block. The order of arrangement is decided such that the ECC blocks are alternately selected. The ECC-encoded main data included in the sectors corresponding to the arranged identifiers are interleaved to generate the recording block. Here, interleaving is performed in units of one or more rows, or in units of at least part of the sectors.

In step 1003, the modulating part 3 modulates the recording block. In step 1004, a recording part 5 records the modulated recording block on an optical disc 100.

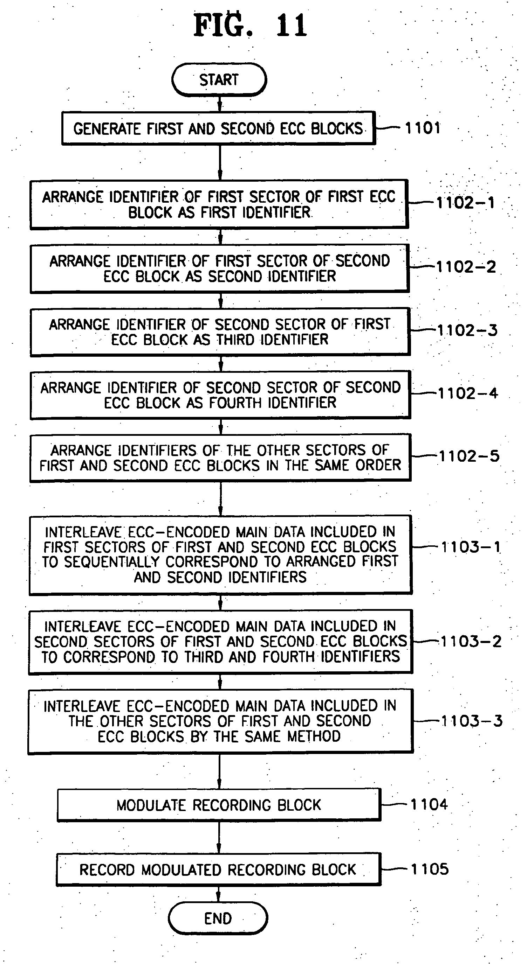

Figure 11 is a flow chart illustrating a data recording method according to the preferred embodiment of the present invention. Referring to Figure 11, in step 1101, the ECC encoder 11 ECC-encodes main data to generate first and second ECC blocks.

In step 1102-1, the interleaver 12 arranges an identifier of the first sector of the first ECC block as a first identifier, arranges an identifier of the first sector of the second ECC block as a second identifier in step 1102-2, arranges an identifier of the second sector of the first ECC block as a third identifier in step 1102-3, arranges the identifier of a second sector of the second ECC block as a fourth identifier in step 1102-4, and arranges identifiers of the remaining sectors of the first and second ECC blocks in the same order in step 1102-5. Here, the interleaver 12 interleaves the ECC-encoded main data included in the first sectors of the first and second ECC blocks to sequentially correspond to the arranged first and second identifiers in step 1103-1, interleaves the ECC-encodedw main data included in the second sectors of the first and second ECC blocks to correspond to third and fourth identifiers in step 1103-2, and interleaves the ECC-encoded main data included in the remaining sectors of the first and second ECC blocks by the same method in step 1103-3, thereby generating the recording block.

In step 1104, the modulating part 3 modulates the recording block. In step 1105, the recording part 5 records the modulated recording block on the optical disc 100.

As described above, according to the present invention, the optical information recording medium, the data recording apparatus, and the data recording method used by the apparatus, which have higher error correction rates in recording/reading data, are provided. Further, according to the present invention, identifiers included in sectors are alternately and equally extracted and arranged in the recording block, thereby searching main data at a high speed together with lower error rates. Furthermore, according to the preferred embodiment of the present invention, an optical information recording medium, a data recording apparatus, and a data recording method used by the apparatus, which are compatible with the format of a conventional digital versatile disc (DVD) and have higher error correction rates, are provided.

While this invention has been particularly shown and described with reference to preferred embodiments thereof, it will be understood by those skilled in the art that various changes in form and details may be made therein without departing from the scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method for recording main data on an optical information recording medium, the method comprising the steps of:
(a) error correction code (ECC)-encoding main data to generate a plurality of ECC blocks (A,B); wherein each ECC block comprises a plurality of sectors (A1-A16,B1-B16) having corresponding identifiers (1-32); and
(b) extracting and arranging the identifiers (1-32) from ones of the ECC blocks to generate a recording block;
**characterised by** arranging the identifiers such that adjacent identifiers are of different ECC blocks.

2. The method as claimed in claim 1, further comprising the steps of:
(c) modulating the generated recording block; and
(d) recording the modulated recording block.

3. The method as claimed in claim 1 or 2, wherein the step (b) includes the steps of:
(b1) alternately and equally extracting and arranging the identifiers at predetermined intervals; and
(b2) interleaving ECC-encoded main data included in the sectors corresponding to the arranged identifiers.

4. The method as claimed in claim 3, wherein the step (b2) of interleaving the ECC encoded main data is performed in units of one or more rows.

5. The method as claimed in claim 3 or 4, wherein the step (b2) of interleaving the ECC encoded main data is performed in units of at least a part of the sectors.

6. A method for recording main data on an optical information recording medium, the method comprising the step of:
(a) error correction code (ECC)-encoding main data to generate first and second ECC blocks (A,B), each of the first and second ECC blocks comprising sectors and each sector having an identifier (1-32);
**characterised by** the further steps of:
(b) arranging an identifier (1) included in a first one of the sectors (A1) of the first ECC block (A) as a first identifier, arranging an identifier (2) included in a first one of the sectors (B1) of the second ECC block (B) as a second identifier, arranging an identifier (3) included in a second one of the sectors (A2) of the first ECC block (A) as a third identifier, arranging an identifier (4) included in a second one of the sectors (B2) of the second ECC block (B) as a fourth identifier, and arranging identifiers (5-32) included in the remaining sectors (A3-A16,B3-B16) of the first and second ECC blocks (A,B) with the same alternating pattern; and
(c) interleaving ECC-encoded main data included in the first sectors (A1,B1) of the first and second ECC blocks (A,B) to sequentially correspond to the first arranged identifier (1) and the second arranged identifier (2), interleaving ECC-encoded main data included in the second sectors (A2,B2) of the first and second ECC blocks (A,B) to correspond to the third and fourth arranged identifiers (3,4), and interleaving ECC-encoded main data included in the remaining sectors (A3-A16,B3-B16) of the first and second ECC blocks (A,B) with the same algorithm to generate a recording block.

7. The method as claimed in claim 6, further comprising the steps of:
(d) modulating the generated recording block; and
(e) recording the modulated recording block.

8. The method as claimed in claim 6 or 7, wherein the identifiers are alternately and equally extracted and arranged at predetermined intervals in the step (b).

9. The method as claimed in claim 6, 7 or 8 wherein the step (c) of interleaving of the ECC-encoded main data is performed in units of one or more rows.

10. The method as claimed in claim 6, 7, 8 or 9 wherein said step (c) of interleaving is performed in units of at least a part of the sectors.

11. The method according to claim 7, wherein said modulating method is an eight to fourteen modulation plus (EFM+).

12. The method according to claim 7, wherein the recording of the modulated recording block includes recording a channel bit stream pulse that is converted from a modulated bit stream by non return to zero inversion coding.
